# EUROPEAN PATENT APPLICATION

(11) **EP 4 550 660 A1**
(43) Date of publication of application: **07.05.2025**
(21) Application number: 23839874.7
(22) Date of filing: 05.07.2023
(51) Int. Cl.: H03F 1/02, H03F 3/21, H03F 3/24, H04B 1/04, H03F 3/189, G06F 1/3203

(54) **ELECTRONIC DEVICE, AND METHOD FOR WIRELESS COMMUNICATION THEREIN**

(30) Priority: 12.07.2022 KR 20220085515; 19.09.2022 KR 20220118082
(71) Applicant: Samsung Electronics Co., Ltd., Suwon-si, Gyeonggi-do 16677 (KR)
(72) Inventor: HWANG, Nayoung, Suwon-si Gyeonggi-do 16677 (KR); PAIK, Minchull, Suwon-si Gyeonggi-do 16677 (KR)
(74) Representative: Walaski, Jan Filip
(86) International application number: PCT/KR2023/009525
(87) International publication number: WO 2024/014781

(57) **Abstract**

The present document relates to an electronic device and a method for wireless communication, the electronic device comprising: a wireless communication circuit; and a processor electrically connected to the wireless communication circuit. The wireless communication circuit may comprise: a radio frequency processing circuit; a plurality of power amplification circuits; a first power modulator and a second power modulator for controlling a voltage outputted to at least one power amplification circuit that is connected, among the plurality of power amplification circuits; and a power switch for connecting a first power amplification circuit, among the plurality of power amplification circuits, to the first power modulator or the second power modulator.

## Description

### [Technical Field]

Embodiments of the disclosure relate to an electronic device and a method for wireless communication in the electronic device.

### [Background Art]

Electronic devices are providing more diversified services and additional functions. Steady development efforts are underway for electronic devices to meet various needs of users and to raise the usability of electronic devices. As an example of satisfying user's needs, an electronic device may transmit and receive data to/from an external electronic device. For such data transmission and reception, the radio frequency (RF) circuit of the electronic device may provide a voltage controlled by a power modulator to a power amplifier (PA), thereby transmitting and receiving signals.

In the network environment of 4G/5G communication schemes, power control of the PA for wireless communication is becoming important, and power tracking components (power tracking ICs) are being applied to electronic devices for PA power management. In the network environment of 4G/5G communication schemes, electronic devices must be able to control each PA simultaneously to support uplink (UL) carrier aggregation (CA) or EN-DC that supports simultaneous transmission (simultaneous 2Tx) of transmission signals for wireless communication. Simultaneous control of PAs for simultaneous 2Tx support may be limited by, e.g., the mounting space of the components (ICs), complexity of the circuit lines, and costs.

### [Detailed Description of the Invention]

### [Technical Solution]

According to an embodiment of the disclosure, an electronic device may comprise a wireless communication circuit and a processor electrically connected to the wireless communication circuit. According to an embodiment, the wireless communication circuit may include a radio frequency processing circuit, a plurality of power amplification circuits, a first power modulator and a second power modulator configured to adjust a voltage output to at least one power amplification circuit connected among the plurality of power amplification circuits, and a power switch configured to connect a first power amplification circuit among the plurality of power amplification circuits to the first power modulator or the second power modulator. According to an embodiment, the processor may be configured to identify power amplification circuits for amplifying, respectively, transmission signals input to the radio frequency processing circuit. According to an embodiment, the processor may be configured to, based on the identified power amplification circuits being connected to the first power modulator, control the power switch to connect the first power amplification circuit among the identified power amplification circuits to the second power modulator to simultaneously transmit the transmission signals using the identified power amplification circuits. According to an embodiment, the processor may be configured to, based on the identified power amplification circuits being connected to the different first power modulator and second modulator, respectively, control the power switch to connect the first power amplification circuit among the identified power amplification circuits to the first power modulator to simultaneously transmit the transmission signals using the identified power amplification circuits.

According to an embodiment, a method for operation in an electronic device may comprise identifying power amplification circuits supporting different frequency bands for amplifying, configured to transmission signals input through a wireless communication circuit of the electronic device.

According to an embodiment, the method for operation in the electronic device may comprise, based on the identified power amplification circuits being connected to a first power modulator included in the wireless communication circuit, controlling a power switch included in the wireless communication circuit to connect a first power amplification circuit among the identified power amplification circuits to a second power modulator included in the wireless communication circuit to simultaneously transmit the transmission signals using the identified power amplification circuits.

According to an embodiment, the method for operation in the electronic device may comprise, based on the identified power amplification circuits being connected to the different first power modulator and second modulator, respectively, controlling the power switch to connect a first power amplification circuit among the identified power amplification circuits to the first power modulator to simultaneously transmit the transmission signals using the identified power amplification circuits.

### [Brief Description of the Drawings]

FIG. 1 is a view illustrating an electronic device in a network environment according to various embodiments;
FIG. 2 is a block diagram illustrating an example of a configuration of an electronic device for wireless communication according to an embodiment;
FIG. 3 is a block diagram illustrating an example of a configuration of an electronic device for wireless communication according to an embodiment;
FIGS. 4A, 4B, and 4C are circuit diagrams illustrating an example of a configuration of a wireless communication circuit of an electronic device for wireless communication according to an embodiment;
FIGS. 5A and 5B are circuit diagrams illustrating an example of a configuration of a wireless communication circuit of an electronic device for wireless communication according to an embodiment; and
FIG. 6 is a flowchart illustrating an operation method in an electronic device according to an embodiment.

In connection with the description of the drawings, the same or similar reference numerals may be used to denote the same or similar elements.

### [Mode for Carrying out the Invention]

The terms as used herein are provided merely to describe some embodiments thereof, but not to limit the scope of other embodiments of the present disclosure. It is to be understood that the singular forms "a," "an," and "the" include plural references unless the context clearly dictates otherwise. All terms including technical and scientific terms used herein have the same meaning as commonly understood by one of ordinary skill in the art to which the embodiments of the present disclosure belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some cases, the terms defined herein may be interpreted to exclude embodiments of the present disclosure.

Conventional pre-5G electronic devices transmitted signals through a single power modulator, and thus could not efficiently perform uplink carrier aggregation (CA) and EN-DC, which configure multiple transmission signals simultaneously. When electronic devices use techniques, such as envelope tracking (ET) or average power tracking (APT) to enhance transmission power efficiency, the power amplifier (PA) supply voltage output from the power modulator becomes dependent on the PA output power. Since the output power of each PA is independent during uplink CA operation, conventional electronic devices have difficulty efficiently supporting uplink CA operation in which multiple PAs operate with a single power modulator, and could not support uplink CA using a similar band. For example, where all of the frequencies to be used for uplink CA belong to a mid band (MB), the conventional electronic device could not perform uplink CA due to insufficient PAs for use.

According to an embodiment of the disclosure, there may be provided a method for wireless communication in which an electronic device efficiently supports an uplink CA operation in which a plurality of PAs are operated with one power modulator through a minimum power modulator configuration and supports uplink CA and EN-DC of a combination of all frequency bands to simultaneously transmit transmission signals (2Tx).

Various embodiments of the present disclosure are now described with reference to the accompanying drawings.

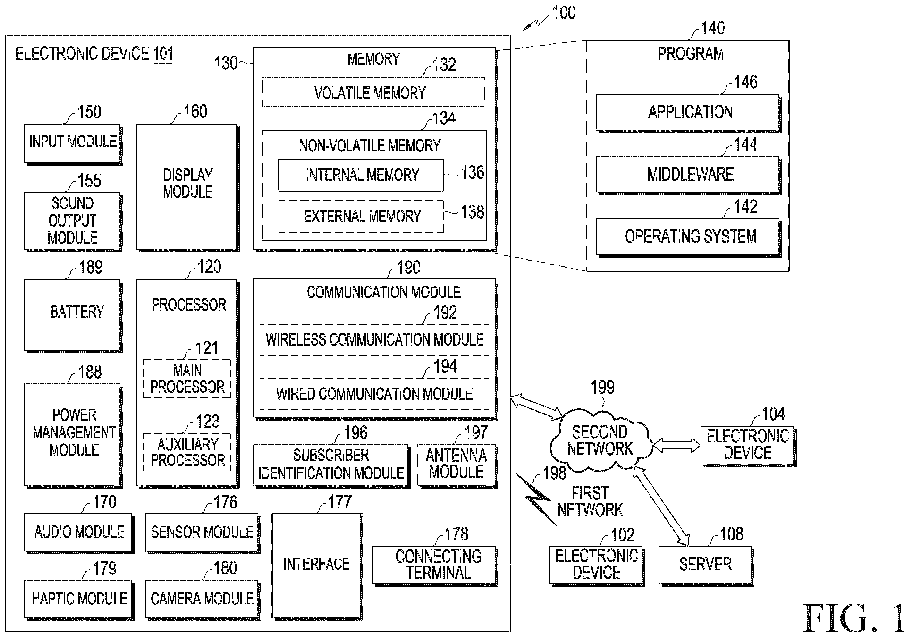

FIG. 1 is a block diagram illustrating an electronic device 101 in a network environment 100 according to various embodiments. Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

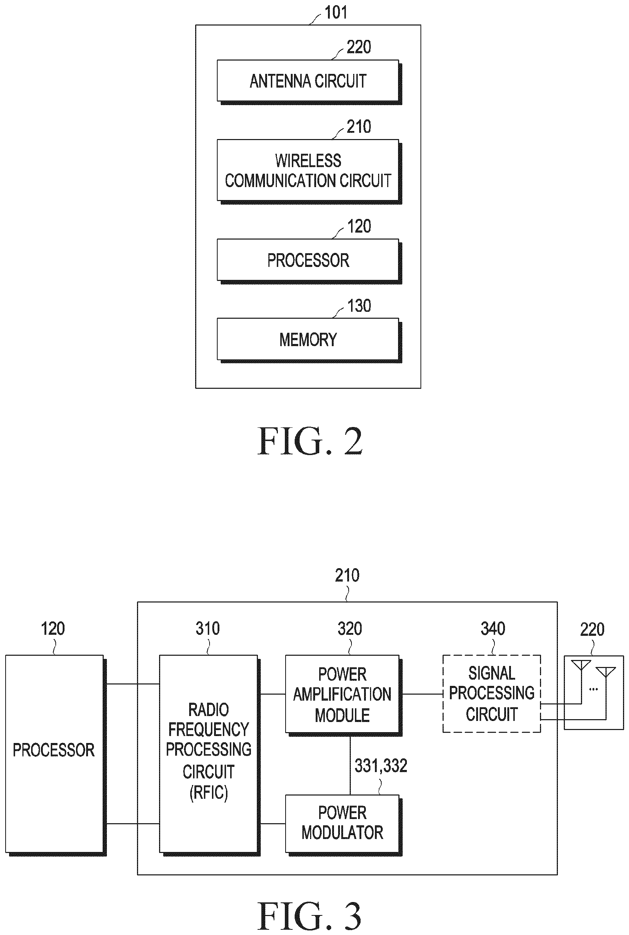

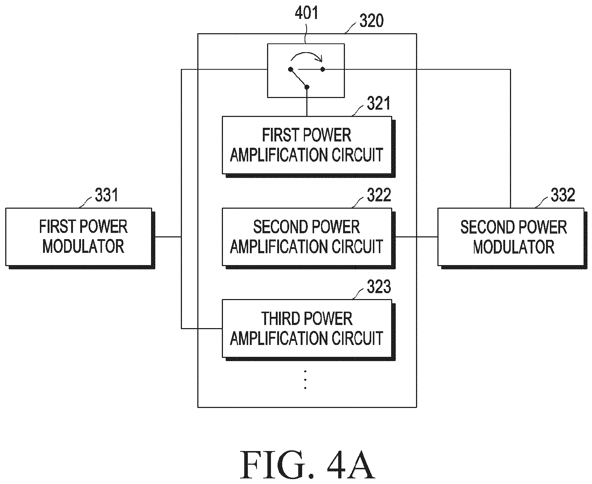

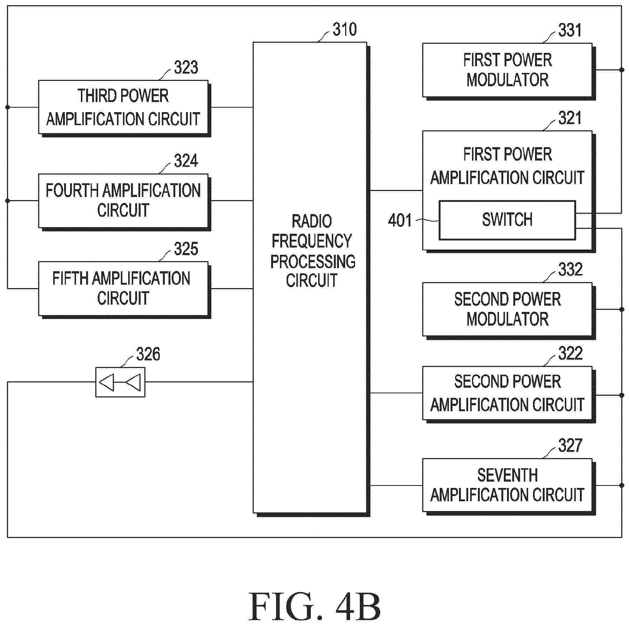

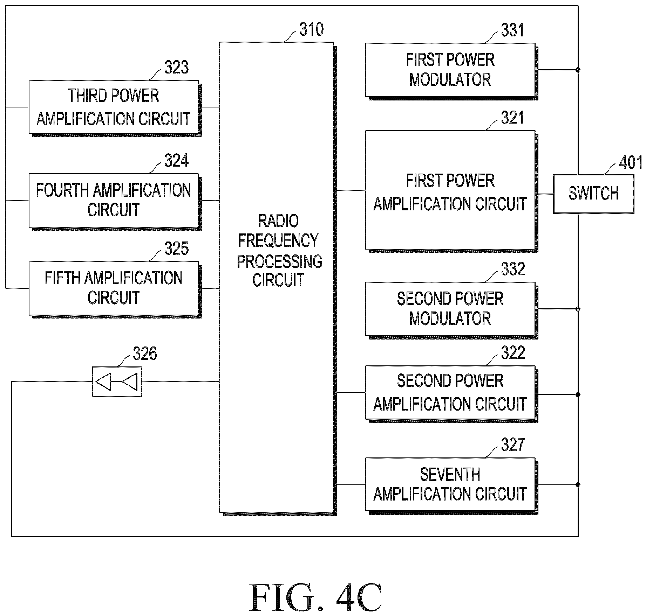

FIG. 2 is a block diagram illustrating an example of a configuration of an electronic device for wireless communication according to an embodiment. FIG. 3 is a block diagram illustrating an example of a configuration of an electronic device for wireless communication according to an embodiment. FIGS. 4A, 4B, and 4C are circuit diagrams illustrating an example of a configuration of a wireless communication circuit of an electronic device for wireless communication according to an embodiment.

Referring to FIGS. 2 and 3, an electronic device 101 (e.g., the electronic device 101 of FIG. 1) according to an embodiment may include a processor 120, memory 130, a wireless communication circuit 210 (e.g., the wireless communication module 192 of FIG. 1), and an antenna circuit 220 (e.g., the antenna module 197 of FIG. 1). The electronic device (e.g., the electronic device 101 of FIG. 1) according to an embodiment may process transmission signals (e.g., 2Tx) to be simultaneously transmitted by the wireless communication circuit 210, and may simultaneously transmit transmission signals to an external electronic device through the antenna circuit 220.

According to an embodiment, the processor 120 may be electrically connected to the memory 130, the wireless communication circuit 210 (e.g., the wireless communication module 192 of FIG. 1), and the antenna circuit 220. The processor 120 may wirelessly process the input transmission signals (e.g., baseband signals) and control the wireless communication circuit 210 to simultaneously transmit the processed transmission signals (e.g., amplified RF signals). The processor 120 may be a communication processor for controlling signal transmission or reception processing. According to an embodiment, the processor 120 may identify a power amplification circuit to process transmission signals using a designated frequency band combination, and control the identified power amplification circuits to simultaneously transmit the amplified transmission signals in each of the identified power amplification circuits. For example, the processor 120 may control to be able to use one of different frequency bands for first communication by the first communication scheme and the other for second communication by the second communication scheme, based on a combination of the frequency bands (e.g., a combination of E-UTRAN new radio dual connectivity (ENDC) schemes) for the first communication scheme and the second communication scheme as necessary for the same frequency band. For example, the first communication scheme may be a 5G (e.g., NR) communication scheme, and the second communication scheme may be a 4G (e.g., LTE) communication scheme. For example, the processor 120 may perform uplink CA to simultaneously transmit transmission signals amplified through the same communication scheme (e.g., 5G + 5G, 4G, or 4G) in each of the identified power amplification circuits.

According to an embodiment, as illustrated in FIG. 3, the wireless communication circuit 210 may include a radio frequency processing circuit (radio frequency integrated circuit (RFIC)) 310, a power amplification module 320 including a plurality of power amplification circuits, and power modulators 331 and 332. The wireless communication circuit 210 may be connected to an antenna circuit 220 including a plurality of antennas 221. Here, each of the plurality of power amplification circuits may be implemented as an individual component (e.g., an IC) or an integrated component. According to an embodiment, the wireless communication circuit 210 may further include a signal processing circuit 340 (e.g., a front-end module with integrated duplexers (FEMID)). The disclosure is not limited thereto, and the signal processing circuit 340 may not be separately configured according to various implementation forms, but may be included in the power amplification module 320 or may be included in each of the plurality of power amplification circuits, or may be configured to include all components configured between the radio frequency processing circuit 310 and the antenna circuit 220. According to various implementation forms, some components of the signal processing circuit may be configured to be included in the plurality of power amplification circuits. According to an embodiment, the signal processing circuit 340 may be connected to the antenna circuit 220 and may process transmission signals output by the power amplification circuits to be simultaneously transmitted through the antenna circuit 220. The signal processing circuit 340 may include switches (not shown), a diplexer, and/or a duplexer (not shown) connected to the antenna circuit 2220, and may select a transmission path for transmitting transmission signals through the switches, the diplexer, and/or the duplexer.

According to an embodiment, the wireless communication circuit 210 may be a device for transmission processing of a wireless signal, but is not limited thereto, and may further include components for reception processing of a wireless signal. The wireless communication circuit 210 may perform wireless communication in a scheme (e.g., an E-UTRAN new radio dual connectivity (ENDC) scheme) for increasing the data transmission speed by supporting both the first communication scheme and the second communication scheme, and may selectively perform first communication of the first communication scheme or second communication of the second communication scheme if necessary. In an embodiment, the frequency band of the first communication scheme may use a wider broadband and a higher frequency band than the frequency band of the second communication scheme. A portion (a portion of the middle band) of the frequency band of the second communication scheme may be used in the first communication scheme, and thus a partial overlap may occur between the two frequency bands, and thus the two frequency bands may be configured to be selectively used.

According to an embodiment, the radio frequency processing circuit 310 of the wireless communication circuit 210 is an RF circuit for wireless communication, and may be a transceiver that performs signal processing for transmitting and/or receiving a wireless signal, and may be controlled by the processor 120 (e.g., the processor 120 of FIG. 1). The radio frequency processing circuit 310 may convert transmission signals, which are baseband signals input for simultaneous transmission, into RF signals, and output RF signals converted by identified power amplification circuits under the control of the processor 120.

According to an embodiment, the radio frequency processing circuit 310 may output the simultaneous transmission signals (e.g., the first transmission signal and the second transmission signal) input to at least two of the plurality of power amplification circuits 321, 322, and 323 of the power amplification module 320, respectively, under the control of the processor 120. The radio frequency processing module 310 may process a frequency band to transmit transmission signals, based on a combination of frequency bands for the first communication scheme and the second communication scheme. For example, the power amplification circuits may be multimode multiband (MMMB)-type power amplification circuits.

According to an embodiment, the power amplification module 320 may be electrically connected to the radio frequency processing circuit 310 and the power modulators 331 and 332. According to an embodiment, as illustrated in FIGS. 4A to 4C, the power amplification module 320 may include a plurality of power amplification circuits (e.g., the first power amplification circuit 321, the second power amplification circuit 322, and the third power amplification circuit 323 to the nth power amplification circuit) and a power switch 401. Each of the plurality of power amplification circuits may include at least one amplifier for amplifying the transmission signal output from the radio frequency processing circuit 310, and may be controlled by the processor 120 (e.g., the processor 120 of FIG. 1).

According to an embodiment, the power amplification module 320 may input transmission signals output from the radio frequency processing circuit 310 to the identified power amplification circuits, respectively, based on a combination of frequency bands, and may amplify the input transmission signal. For example, the combination of frequency bands may be configured by combining frequency bands (e.g., low band (LB), middle band (MB), and high band (HB) or ultra-high band (UHB)) of the first communication scheme and frequency bands (e.g., LB, MB, and HB) of the second communication scheme. The combination of frequency bands may be set to various combinations according to the business operator, the service, etc.

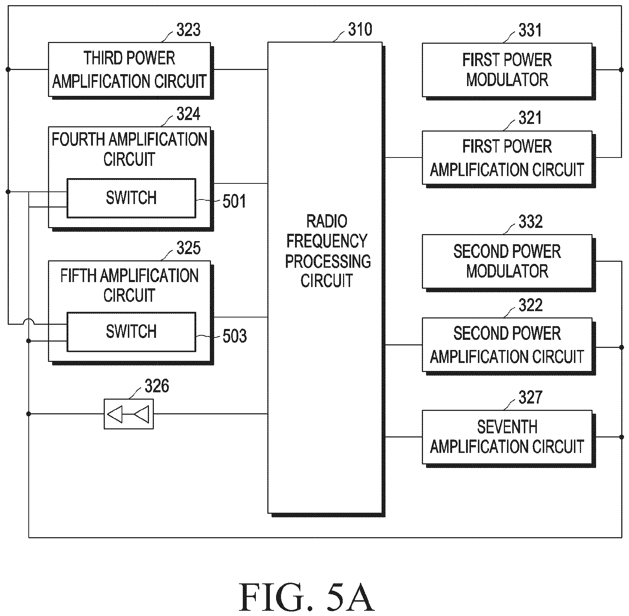

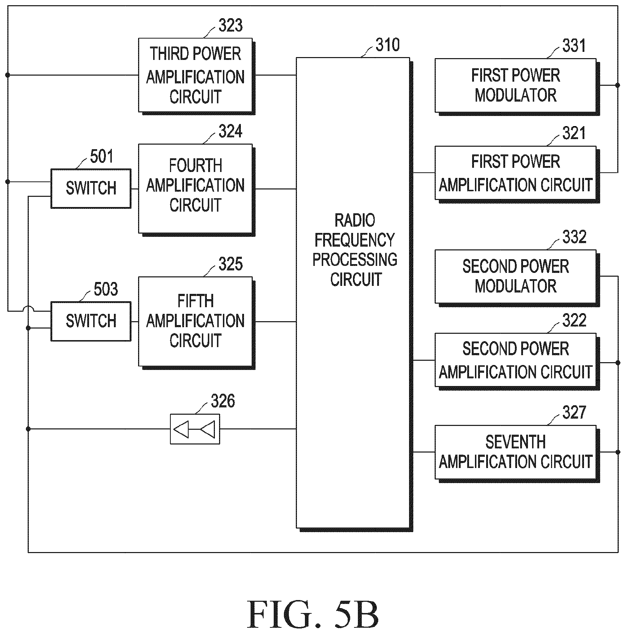

According to an embodiment, the power switch 401 may be connected to one of the plurality of power amplification circuits. The power switch 401 may be configured to be connected to or included in a power amplification circuit having a low use frequency or a designated power amplification circuit, and may be selectively connected to the first power modulator 331 or the second power modulator 332 by switching to the first power modulator 331 or the second power modulator 332 under the control of the processor 120. For example, the power switch 401 may be included in and connected to the first power amplification circuit 321 as illustrated in FIG. 4B, or may be configured outside and connected to the first power amplification circuit 321 as illustrated in FIG. 4C. The power switch 401 is not limited to the first power amplification circuit 321, and may be included in or connected to another power amplification circuit (e.g., the second power amplification circuit 322, the third power amplification circuit 323, or another power amplification circuit) among the plurality of power amplification circuits. For example, as illustrated in FIGS. 5A and 5B, the fourth power amplification circuit 324 and/or the fifth power amplification circuit 325 may include or be connected to at least one power switch (at least one of 501 or 503). At least one power switch (at least one of 501 or 503) may be the power switch 401 of FIG. 4A or another added power switch.

According to an embodiment, the first power amplification circuit 321 among the plurality of power amplification circuits may be connected to the power switch 401 and may be connected to the first power modulator 331 by default. According to an embodiment, the first power amplification circuit 321 may be selectively connected to the first power modulator 331 or the second power modulator 332 through switching of the power switch 401. For example, as illustrated in FIGS. 4B, 4B, 5A, and 5B, the first power amplification circuit 321 may be a power amplification circuit supporting low frequency bands LB1 and LB2. Without being limited thereto, the first power amplification circuit 321 may be a power amplification circuit supporting another frequency band (e.g., MB, HB, or UHB). According to an embodiment, the first power amplification circuit 321 may support, e.g., the first communication scheme and/or the second communication scheme.

According to an embodiment, if the power amplification circuit (e.g., the third power amplification circuit 323) for processing another transmission signal (e.g., the second transmission signal Tx2) to be simultaneously transmitted with the transmission signal (e.g., the first transmission signal Tx1) input from the radio frequency processing circuit 310 is connected to the same power modulator (e.g., the first power modulator 331), the first power amplification circuit 321 may be connected to another power modulator (e.g., the second power modulator 332) by the power switch 401.

According to an embodiment, if the power amplification circuit (e.g., the second power amplification circuit 332) for processing another transmission signal (e.g., the second transmission signal Tx2) to be simultaneously transmitted with the transmission signal (e.g., the first transmission signal Tx1) input from the radio frequency processing circuit 310 is connected to another power modulator (e.g., the second power modulator 331), the first power amplification circuit 321 may be connected to the default power modulator (e.g., the first power modulator 331) by the power switch 401.

According to an embodiment, the second power amplification circuit 322 among the plurality of power amplification circuits may be connected by default to the second power modulator 332 connected to the power switch 401. For example, as illustrated in FIGS. 4B, 4C, 5A, and 5B, the second power amplification circuit 322 may be a power amplification circuit supporting a middle frequency band MB and/or a high frequency band HB. Without being limited thereto, the second power amplification circuit 322 may be a power amplification circuit supporting another frequency band (e.g., LB or UHB). According to an embodiment, the second power amplification circuit 322 may support, e.g., the first communication scheme and/or the second communication scheme.

According to an embodiment, the third power amplification circuit 323 among the plurality of power amplification circuits may be connected to the first power modulator 331 by default. For example, as illustrated in FIGS. 4B, 4C, 5A, and 5B, the third power amplification circuit 323 may be a power amplification circuit supporting a frequency band MB and/or a high frequency band HB. Without being limited thereto, the third power amplification circuit 323 may be a power amplification circuit supporting another frequency band (e.g., LB or UHB). According to an embodiment, the third power amplification circuit 323 may support, e.g., the first communication scheme and/or the second communication scheme.

According to an embodiment, the first power modulator 331 may be connected to the first power amplification circuit 321 through the power switch 401, and may be connected to the third power amplifier 333 and at least one other power amplification circuit (e.g., the fourth power amplification circuit 334 and/or the fifth power amplification circuit 335 of FIGS. 4B, 4C, 5A, and 5B).

According to an embodiment, the second power modulator 332 may be connected to the first power amplification circuit 321 through the power switch 401, and may be connected to the second power amplification circuit 322 and at least one other power amplification circuit (e.g., the sixth power amplification circuit 336 and/or the seventh power amplification circuit 336 of FIGS. 4B, 4B, 5A, and 5B).

According to an embodiment, the first power modulator 331 may supply power to at least one connected power amplification circuit, and the second power modulator 332 may supply power to at least one other connected power amplification circuit, so that the wireless communication circuit 210 may simultaneously perform 2Tx transmission such as uplink CA and EN-DC having two uplink component carriers by simultaneously using the at least one power amplification circuit and at least one other power amplification circuit.

Referring to FIGS. 2 to 4C, the processor 120 according to an embodiment may identify power amplification circuits for processing to simultaneously transmit input transmission signals (e.g., Tx1 and Tx2) using a combination of designated frequency bands.

According to an embodiment, if it is identified that the identified power amplification circuits are connected to the same power modulator (e.g., the first power modulator 331 of FIGS. 4A to 4C), the processor 120 may control the power switch 401 to connect one power amplification circuit (e.g., the first power amplification circuit 321 of FIGS. 4A to 4C) among the identified power amplification circuits to another power modulator (e.g., the third power modulator 333 of FIGS. 4A to 4C). According to an embodiment, as illustrated in FIGS. 4A to 4C, the processor 120 may control the first power amplification circuit 321 connected to the second power modulator 332 to amplify and output the first transmission signal Tx1, and may control the third power amplification circuit 323 connected to the first power modulator 331 to amplify and output the second transmission signal Tx2. The processor 120 may control the signal processing circuit 340 of the wireless communication circuit 210 to simultaneously transmit the first transmission signal and the second transmission signal output from the first power amplification circuit 321 and the third power amplification circuit 323, respectively, through the antenna circuit 220.

According to an embodiment, when it is identified that the identified power amplification circuits are connected to different power modulators (e.g., the first power modulator 331 and the second power modulator 332 of FIGS. 4A to 4C), the processor 120 may control the power switch 401 to connect one power amplification circuit (e.g., the first power amplification circuit 321 of FIGS. 4A to 4C) among the identified power amplification circuits to a default power modulator (e.g., the first power modulator 331 of FIGS. 4A to 4C). Here, the identified power amplification circuits may support different frequency bands. According to an embodiment, as illustrated in FIGS. 4A to 4C, the processor 120 may control the first power amplification circuit 321 connected to the first power modulator 332 to amplify and output the first transmission signal Tx0, and may control the second power amplification circuit 322 connected to the second power modulator 332 to amplify and output the second transmission signal Tx1. The processor 120 may control the signal processing circuit 340 of the wireless communication circuit 210 to simultaneously transmit the first transmission signal and the second transmission signal output from the first power amplification circuit 321 and the second power amplification circuit 322, respectively, through the antenna circuit 220.

According to an embodiment, as illustrated in FIGS. 4A to 4C, the processor 120 may identify that transmission signals Tx0 and Tx1 input using a designated frequency band combination are simultaneously transmitted through, e.g., an LB and MB combination TX0(LB) + TX1(MB). When the first power amplification circuit 321 supporting the LB and the second power amplification circuit 322 supporting the MB (e.g., the first PA (LB) + the second PA (MB)) are identified according to the combination of the LB and the MB (TX0(LB) + TX1(MB)), the processor 120 may identify that the first power amplification circuit 321 and the second power amplification circuit 323 are connected by default to the first power modulator 331 and the second power modulator 332, which are different power modulators, as shown in Table 1 below, and control the power switch 401 to connect the first power amplification circuit 321 to the first power modulator 331 and connect the second power amplification circuit 322 to the second power modulator 332. Here, the first power amplification circuit 321 may support an LB (e.g., LB1 or LB2), and may be connected to the first power modulator 331 by default. The second power amplification circuit 322 may support an MB (e.g., MB1 or HB1) and may be connected to the first power modulator 331 by default.

According to an embodiment, when the first power amplification circuit 321 supporting the LB and the third power amplification circuit 323 supporting the MB (e.g., the first PA (LB) + the third PA (MB)) are identified according to the combination of the LB and the MB (TX0(LB) + TX1(MB)), the processor 120 may identify that the first power amplification circuit 321 and the second power amplification circuit 323 are connected by default to the first power modulator 331, as the same power modulator, as shown in Table 1 below, and control the power switch 401 to connect the first power amplification circuit 321 to the second power modulator 332 and connect the third power amplification circuit 323 to the first power modulator 331. Here, the third power amplification circuit 323 may support an MB (e.g., MB1 or HB1), and may be connected to the second power modulator 332 by default.

**[Table 1]**

| | First power modulator (Modulator_#0) | Second power modulator (Modulator_#1) |
|---|---|---|
| first PA(LB) + second PA(MB or HB) | first PA connection | second PA connection |
| first PA(LB) + third PA(MB or HB) | third PA connection | first PA connection |
| first PA(LB) + fourth PA(UHB) or fifth PA(MB2) | fourth PA or fifth PA connection | first PA connection |
| first PA(LB) + sixth PA(LB2) or seventh PA(MB) | first PA connection | sixth PA or seventh PA connection |

According to an embodiment, the processor 120 may identify the first power amplification circuit (first PA) and another power amplification circuit PA (e.g., one of the fourth PA 334 to the seventh PA 337 of FIGS. 4B and 4C) and may control the power switch 401 to connect the first power amplification circuit and the other power amplification circuit to the first power modulator and the second power modulator by the power switch, as shown in Table 1 above. Here, the fourth power amplification circuit 324 may support a UHB (e.g., B48/n77) and may be connected to the first power modulator 331 by default. The fifth power amplification circuit 325 may support a specific MB (e.g., B2/n2) and may be connected to the first power modulator 331 by default. The sixth power amplifier 326 may support a specific LB (e.g., B5/n5) and may be connected to the second power modulator 332 by default. The seventh power amplifier 326 may support a specific MB (e.g., the JB B21) and may be connected to the second power modulator 332 by default.

According to an embodiment, the signal processing circuit 340 may simultaneously transmit the first transmission signal and the second transmission signal, which are simultaneously input from the identified power amplification circuits, through the antenna circuit 220.

FIGS. 5A and 5B are circuit diagrams illustrating an example of a configuration of a wireless communication circuit of an electronic device for wireless communication according to an embodiment.

Referring to FIGS. 5A and 5B, the wireless communication circuit 220 of the electronic device 101 according to an embodiment may connect or include power switches 501 and 503 to/in at least two power amplification circuits (e.g., the fourth power amplification circuit 324 and the fifth power amplification circuit 325), respectively, among the plurality of power amplification circuits.

According to an embodiment, the power switch 501 (e.g., the power switch 401 of FIGS. 4A to 4C) may be connected to be connected to or included in the fourth power amplification circuit 324 instead of the first power amplification circuit 321. The power switch 503, as an additional power switch, may be configured to be connected to or included in the fifth power amplification circuit 325.

According to an embodiment, the fourth power amplification circuit 324 may be selectively connected to the first power modulator 331 or the second power modulator 332 by the power switch 501 to receive power. According to an embodiment, the fifth power amplification circuit 325 may be selectively connected to the first power modulator 331 or the second power modulator 332 by the power switch 503 to receive power.

According to an embodiment, the processor 120 may identify power amplification circuits for amplifying, respectively, the input transmission signals, and if it is identified that the identified power amplification circuits are identically connected to the first power modulator 331, the processor 120 may control to connect the second power modulator 332 to the fourth power amplification circuit 324 connected to the power switch 501 and/or the fifth power amplification circuit 325 connected to the power switch 503.

According to an embodiment, the processor 120 may identify power amplification circuits for amplifying, respectively, the input transmission signals, and if it is identified that the identified power amplification circuits are connected to the first power modulator 331 and the second power modulator 3322, respectively, which are different from each other, the processor 120 may control to connect the first power modulator 331 to the fourth power amplification circuit 324 connected to the power switch 501 and/or the fifth power amplification circuit 325 connected to the power switch 503.

As such, in an embodiment, the main components of the electronic device have been described through the electronic device 101 of FIGS. 1 and 2. According to an embodiment, however, all of the components of FIGS. 1 and 2 are not essential components, and the electronic device 101 may be implemented with more or less components than those shown. The positions of the major components of the electronic device 101 described above in connection with FIGS. 1 and 2 may be varied according to various embodiments of the present invention.

According to an embodiment, an electronic device (e.g., the electronic device 101 of FIGS. 1 and 2) may comprise a wireless communication circuit (e.g., the wireless communication circuit 210 of FIGS. 2 and 3) and a processor (e.g., the processor 120 of FIGS. 1 and 2) electrically connected to the wireless communication circuit. The wireless communication circuit may include a radio frequency processing circuit (e.g., the radio frequency processing circuit 310 of FIG. 3), a plurality of power amplification circuits (e.g., the power amplification circuits 321 to 327 of FIGS. 3 to 5B), a first power modulator (e.g., the first power modulator 331 of FIGS. 3 to 5B) and a second power modulator (e.g., the first power modulator 333 of FIGS. 3 to 5B) adjusting a voltage output to at least one power amplification circuit connected among the plurality of power amplification circuits, and a power switch (e.g., the power switch 401 of FIGS. 4A and 4B or the power switch 501 or 503 of FIGS. 5A and 5B) connecting a first power amplification circuit (e.g., the first power amplification circuit 321 of FIGS. 4A to 5B) among the plurality of power amplification circuits to the first power modulator or the second power modulator.

According to an embodiment, the processor may identify power amplification circuits for amplifying, respectively, transmission signals input through the radio frequency processing circuit. Here, the power amplification circuits may support different frequency bands.

According to an embodiment, the processor may, based on the identified power amplification circuits being connected to the first power modulator, control the power switch to connect the first power amplification circuit among the identified power amplification circuits to the second power modulator to simultaneously transmit the transmission signals using the identified power amplification circuits.

According to an embodiment, the processor may, based on the identified power amplification circuits being connected to the different first power modulator and second modulator, respectively, control the power switch to connect the first power amplification circuit among the identified power amplification circuits to the first power modulator to simultaneously transmit the transmission signals using the identified power amplification circuits.

According to an embodiment, the power switch may be connected to the first power amplification circuit, the first power modulator may be connected to the power switch and a third power amplification circuit (e.g., the third power amplification circuit 323 of FIGS. 4A to 5B) among the plurality of amplification circuits, and the second power modulator may be connected to the power switch and a second power amplification circuit (e.g., the second power amplification circuit 322 of FIGS. 4A to 5B) among the plurality of amplification circuits.

According to an embodiment, the processor may control the first power amplification circuit connected to the second power modulator to amplify a first transmission signal among the transmission signals and control the second power amplification circuit connected to the first power modulator to amplify a second transmission signal among the transmission signals. According to an embodiment, the processor may control the wireless communication circuit to simultaneously transmit the first transmission signal amplified by the first power amplification circuit and the second transmission signal amplified by the second power amplification circuit.

According to an embodiment, the processor may control the first power amplification circuit connected to the first power modulator to amplify a first transmission signal among the transmission signals and control the second power amplification circuit connected to the second power modulator to amplify a second transmission signal among the transmission signals. According to an embodiment, the processor may control the wireless communication circuit to simultaneously transmit the first transmission signal amplified by the first power amplification circuit and the second transmission signal amplified by the third power amplification circuit.

According to an embodiment, the first power amplification circuit may include at least one amplifier for amplifying the first transmission signal and a front-end circuit configured to output the first transmission signal output from the at least one amplifier to an antenna connected to the at least one amplifier.

According to an embodiment, the second power amplification circuit or the third power amplifier may include at least one amplifier configured to amplify the second transmission signal. According to an embodiment, the second power amplification circuit or the third power amplifier may include a front-end circuit connected to an antenna connected to the at least one amplifier.

According to an embodiment, the first power amplification circuit may be configured to support any one of a first frequency band, a second frequency band, or a third frequency band, and be connected to the first power modulator or the second power modulator by the power switch based on a combination of frequency bands related to input transmission signals.

According to an embodiment, the second power amplification circuit may be configured to support a different frequency band from the first power amplification circuit and be connected to the first power modulator, and the third power amplification circuit may be configured to support a different frequency band from the first power amplification circuit and be connected to the second power modulator.

According to an embodiment, the processor may control the wireless communication circuit to transmit a first transmission signal among the transmission signals using a first communication scheme. According to an embodiment, the processor may control the wireless communication circuit to transmit a second transmission signal among the transmission signals using a second communication scheme.

According to an embodiment, the wireless communication circuit may further include a power switch configured to be included in or connected to a power amplification circuit configured to support a frequency band of a low output frequency among the plurality of amplification circuits.

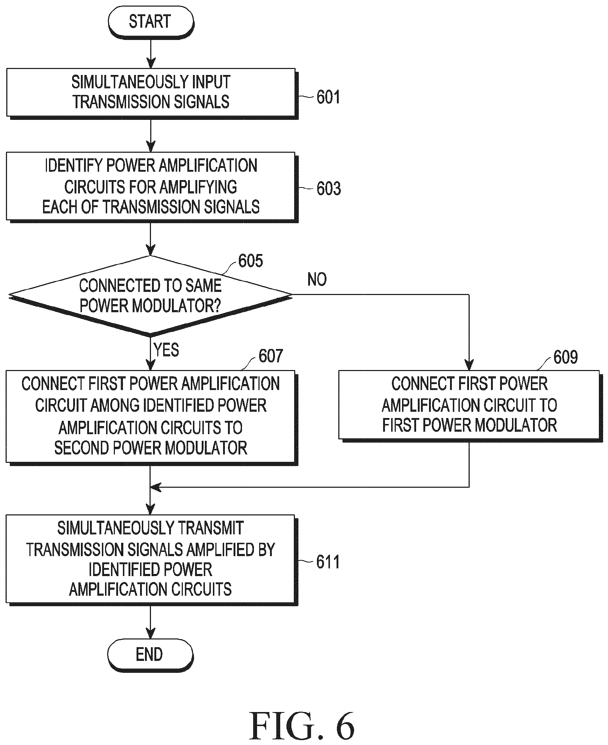

FIG. 6 is a flowchart illustrating an example of an operation method in an electronic device according to an embodiment.

Referring to FIG. 6, an electronic device (e.g., the electronic device 101 of FIGS. 1 and 2) according to an embodiment may input transmission signals Tx1 and Tx2 to be simultaneously transmitted to a wireless communication circuit (e.g., the wireless communication circuit 210 of FIG. 2) in operation 601. The electronic device may convert input transmission signals from baseband signals to RF signals by a radio frequency processing circuit (e.g., the radio frequency processing circuit 310 of FIGS. 4B to 5B) included in the wireless communication circuit.

In operation 603, the electronic device may identify power amplification circuits for processing, respectively, the transmission signals (e.g., the converted RF signals). The electronic device may identify a power amplification circuit to process, respectively, the transmission signals using a designated frequency band combination.

In operation 605, the electronic device may identify whether the identified power amplification circuits are connected to the same power modulator (e.g., the first power modulator 331 of FIGS. 4A to 5B). As a result of the identification, when the identified power amplification circuits are connected to the same power modulator, the electronic device may perform operation 607, otherwise, the electronic device may perform operation 609.

In operation 607, based on identifying that the identified power amplification circuits are connected to the same power modulator, the electronic device may connect one first power amplification circuit among the power amplification circuits identified by the power switch (e.g., the power switch 401 of FIGS. 4A and 4B and the power switches 501 and 503 of FIGS. 5A and 5B) to another power modulator. Here, the first power amplification circuit is a power amplification circuit configured to be connected to, or to include, a power switch, and may be, e.g., the first power amplification circuit 321 illustrated in FIGS. 4A and 4B, but is not limited thereto. The first power amplification circuit may be another power amplification circuit (e.g., any one of the second power amplification circuit 322 to the seventh power amplification circuit 327 of FIGS. 4A and 5B) configured to be connected to, or to include, a power switch. According to an embodiment, the electronic device may control a power switch (e.g., the power switch 401 of FIGS. 4A and 4B) to be connected from a first power modulator (e.g., the first power modulator 331 of FIGS. 4A and 5B) connected by default to a first power amplification circuit (e.g., the first power amplification circuit 321 of FIGS. 4A and 4B) to another second power modulator (e.g., the first power modulator 333 of FIGS. 4A and 5B). Here, the first power amplification circuit may receive power from the first power modulator, amplify the first transmission signal Tx1 among the transmission signals, and output the amplified first transmission signal Tx1 to the antenna circuit 220 through the signal processing circuit 340. When the third power amplification circuit (the third power amplification circuit 321 of FIGS. 4A and 5B) among the plurality of power amplification circuits is identified to process the second transmission signal Tx2 among the transmission signals, the third power amplification circuit may receive power from the first power modulator connected by default, amplify the second transmission signal Tx2, and output the amplified second transmission signal Tx2 to the antenna circuit 220 through the front-end circuit 340.

In operation 609, based on identifying that the identified power amplification circuits are connected to different power modulators, the electronic device may connect the first power amplification circuit to the first power modulator by the power switch. According to an embodiment, the electronic device may control the power switch to connect the first power amplification circuit (the first power amplification circuit 321 of FIGS. 4A and 4B) to the first power modulator (e.g., the first power modulator 331 of FIGS. 4A to 5B) connected by default. Here, the first power amplification circuit may receive power from the first power modulator, amplify the first transmission signal Tx1 among the transmission signals, and output the amplified first transmission signal Tx1 to the antenna circuit through the front-end circuit. In operation 603, the electronic device may identify the second power amplification circuit (the second power amplification circuit 322 of FIGS. 4A and 5B) among the plurality of power amplification circuits as a power amplification circuit for processing the second transmission signal Tx2 among the transmission signals. The second power amplification circuit may receive power from the second power modulator connected by default, amplify the second transmission signal Tx2, and output the amplified second transmission signal Tx2 to the antenna circuit through the signal processing circuit 340. Here, the first power amplification circuit and the second power amplification circuit may simultaneously perform a signal amplification operation, and simultaneously output their simultaneously amplified transmission signals to the antenna circuit.

In operation 611, the electronic device may transmit transmission signals (e.g., amplified RF signals) amplified by the identified power amplification circuits to the external electronic device through the antenna circuit. For example, the electronic device may transmit the first transmission signal among the transmission signals using the first communication scheme, and may transmit the second transmission signal among the transmission signals using the second communication scheme. Here, the first communication scheme may be a 5G communication scheme, and the second communication scheme may be a 4G communication scheme.

According to an embodiment, a method for operation in an electronic device (e.g., the electronic device 101 of FIGS. 1 and 2) may comprise identifying power amplification circuits supporting different frequency bands for amplifying, respectively, transmission signals input through a wireless communication circuit (e.g., the wireless communication circuit 210 of FIGS. 2 and 3) of the electronic device. According to an embodiment, the method for operation in the electronic device may comprise, based on the identified power amplification circuits being connected to a first power modulator (e.g., the first power modulator 331 of FIGS. 3 to 5B) included in the wireless communication circuit, controlling a power switch (e.g., the power switch of FIGS. 4A and 4B or the power switch 501 or 503 of FIGS. 5A and 5B) included in the wireless communication circuit to connect a first power amplification circuit (e.g., the first power amplification circuit 321 of FIGS. 4A to 5B) among the identified power amplification circuits to a second power modulator (e.g., the first power modulator 332 of FIGS. 3 to 5B) included in the wireless communication circuit to simultaneously transmit the transmission signals using the identified power amplification circuits. According to an embodiment, the method may comprise, based on the identified power amplification circuits being connected to the different first power modulator and second modulator, respectively, controlling the power switch to connect a first power amplification circuit among the identified power amplification circuits to the first power modulator to simultaneously transmit the transmission signals using the identified power amplification circuits.

According to an embodiment, the power switch may be connected to the first power amplification circuit, the first power modulator may be connected to the power switch and a third power amplification circuit (e.g., the second power amplification circuit 323 of FIGS. 4A to 5B) among the plurality of amplification circuits, and the second power modulator may be connected to the power switch and a second power amplification circuit (e.g., the second power amplification circuit 322 of FIGS. 4A to 5B) among the plurality of amplification circuits.

According to an embodiment, the method may further comprise controlling the first power amplification circuit connected to the second power modulator to amplify a first transmission signal among the transmission signals. According to an embodiment, the method may further comprise controlling the third power amplification circuit connected to the first power modulator to amplify a second transmission signal among the transmission signals. According to an embodiment, the method may further comprise controlling the wireless communication circuit to simultaneously transmit the first transmission signal amplified by the first power amplification circuit and the second transmission signal amplified by the third power amplification circuit.

According to an embodiment, the method may further comprise controlling the first power amplification circuit connected to the first power modulator to amplify a first transmission signal among the transmission signals. According to an embodiment, the method may further comprise controlling the second power amplification circuit connected to the second power modulator to amplify a second transmission signal among the transmission signals. According to an embodiment, the method may further comprise controlling the wireless communication circuit to simultaneously transmit the first transmission signal amplified by the first power amplification circuit and the second transmission signal amplified by the second power amplification circuit.

According to an embodiment, controlling the wireless communication circuit to simultaneously transmit the first transmission signal amplified by the first power amplification circuit and the second transmission signal amplified by the third power amplification circuit may include controlling the wireless communication circuit to transmit the first transmission signal among the transmission signals using a first communication scheme and controlling the wireless communication circuit to transmit the second transmission signal among the transmission signals using a second communication scheme.

According to an embodiment, controlling the wireless communication circuit to simultaneously transmit the first transmission signal amplified by the first power amplification circuit and the second transmission signal amplified by the second power amplification circuit may include controlling the wireless communication circuit to transmit the first transmission signal among the transmission signals using a first communication scheme and controlling the wireless communication circuit to transmit the second transmission signal among the transmission signals using a second communication scheme.

According to an embodiment, the first power amplification circuit may be configured to support any one of a first frequency band, a second frequency band, or a third frequency band, and be selectively connected to the first power modulator or the second power modulator by the power switch.

According to an embodiment, the second power amplification circuit may support a different frequency band from the first power amplification circuit and be connected to the first power modulator, and the third power amplification circuit may be configured to support a different frequency band from the first power amplification circuit and be connected to the second power modulator.

According to an embodiment, in a non-transitory storage medium storing a program, the program may include instructions that, when executed by a processor (e.g., the processor 120 of FIGS. 1 and 2) of an electronic device (e.g., the electronic device 101 of FIGS. 1 and 2), enable the electronic device to identify power amplification circuits configured to support different frequency bands for amplifying, respectively, transmission signals input through a wireless communication circuit (e.g., the wireless communication circuit 210 of FIGS. 2 and 3) of the electronic device. According to an embodiment, the program may include instructions to enable the electronic device to, based on the identified power amplification circuits being connected to a first power modulator (e.g., the first power modulator 331 of FIGS. 3 to 5B) included in the wireless communication circuit, control a power switch (e.g., the power switch of FIGS. 4A and 4B or the power switch 501 or 503 of FIGS. 5A and 5B) included in the wireless communication circuit to connect a first power amplification circuit (e.g., the first power amplification circuit 321 of FIGS. 4A to 5B) among the identified power amplification circuits to a second power modulator (e.g., the first power modulator 332 of FIGS. 3 to 5B) included in the wireless communication circuit to simultaneously transmit the transmission signals using the identified power amplification circuits. According to an embodiment, the program may include instructions to enable the electronic device to, based on the identified power amplification circuits being connected to the different first power modulator and second modulator, respectively, control the power switch to connect a first power amplification circuit among the identified power amplification circuits to the first power modulator to simultaneously transmit the transmission signals using the identified power amplification circuits.

According to an embodiment, the program may include instructions to enable the electronic device to control the first power amplification circuit connected to the second power modulator to amplify a first transmission signal among the transmission signals. According to an embodiment, the program may include instructions to enable the electronic device to control the third power amplification circuit 323 connected to the first power modulator to amplify a second transmission signal among the transmission signals. According to an embodiment, the program may include instructions to enable the electronic device to control the wireless communication circuit to simultaneously transmit the first transmission signal amplified by the first power amplification circuit and the second transmission signal amplified by the third power amplification circuit.

The electronic device and the method for operation in the electronic device according to an embodiment described above may reduce the costs incurred in implementing a wireless communication circuit, downsize the wireless communication circuit to save the space for mounting in the electronic device, and perform more efficient wireless communication. Other various effects may be provided directly or indirectly in the disclosure.

The embodiments disclosed herein are proposed for description and understanding of the disclosed technology and does not limit the scope of the disclosure. Accordingly, the scope of the disclosure should be interpreted as including all changes or various embodiments based on the technical spirit of the disclosure.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device, comprising:
a wireless communication circuit (210), which comprises:
a radio frequency processing circuit (310);a plurality of power amplification circuits (321,322, 323, 324, 325, 326, 327);a first power modulator (331) and a second power modulator (332) configured to adjust a voltage output to at least one power amplification circuit connected among the plurality of power amplification circuits; and a power switch (401, 501, or 503) configured to connect a first power amplification circuit (321, 324, or 325) among the plurality of power amplification circuits to the first power modulator or the second power modulator; and
a processor (120) electrically connected to the wireless communication circuit, wherein the processor is configured to:
identify power amplification circuits for amplifying, respectively, transmission signals input to the radio frequency processing circuit;
based on the identified power amplification circuits being connected to the first power modulator, control the power switch to connect the first power amplification circuit among the identified power amplification circuits to the second power modulator to simultaneously transmit the transmission signals using the identified power amplification circuits; and
based on the identified power amplification circuits being connected to the different first power modulator and second modulator, respectively, control the power switch to connect the first power amplification circuit among the identified power amplification circuits to the first power modulator to simultaneously transmit the transmission signals using the identified power amplification circuits.

2. The electronic device of claim 1, wherein the power switch is connected to the first power amplification circuit,
wherein the first power modulator is connected to the power switch and a third power amplification circuit (323) among the plurality of amplification circuits,
wherein the second power modulator is connected to the power switch and a second power amplification circuit (322) among the plurality of amplification circuits, and
wherein the processor is configured to:
control the first power amplification circuit connected to the second power modulator to amplify a first transmission signal among the transmission signals;
control the third power amplification circuit connected to the first power modulator to amplify a second transmission signal among the transmission signals; and
control the wireless communication circuit to simultaneously transmit the first transmission signal amplified by the first power amplification circuit and the second transmission signal amplified by the third power amplification circuit.

3. The electronic device of claim 1 or 2, wherein the processor is configured to:
control the first power amplification circuit connected to the first power modulator to amplify a first transmission signal among the transmission signals;
control the second power amplification circuit connected to the second power modulator to amplify a second transmission signal among the transmission signals; and
control the wireless communication circuit to simultaneously transmit the first transmission signal amplified by the first power amplification circuit and the second transmission signal amplified by the second power amplification circuit.

4. The electronic device of any one of claims 1 to 3, wherein the first power amplification circuit includes:
at least one amplifier configured to amplify the first transmission signal; and
a front-end circuit configured to output the first transmission signal output from the at least one amplifier to an antenna connected to the at least one amplifier, and wherein the second power amplification circuit or the third power amplifier includes:
at least one amplifier configured to amplify the second transmission signal; and
a front-end circuit configured to output the second transmission signal output from the at least one amplifier to an antenna connected to the at least one amplifier.

5. The electronic device of any one of claims 1 to 4, wherein the first power amplification circuit is configured to support any one of a first frequency band, a second frequency band, or a third frequency band, and is connected to the first power modulator or the second power modulator by the power switch based on a combination of frequency bands related to input transmission signals,
wherein the second power amplification circuit is configured to support a different frequency band from the first power amplification circuit and is connected to the second power modulator, and
wherein the third power amplification circuit is configured to support a different frequency band from the first power amplification circuit and is connected to the first power modulator.

6. The electronic device of any one of claims 1 to 5, wherein the processor is configured to:
control the wireless communication circuit to transmit a first transmission signal among the transmission signals using a first communication scheme; and
control the wireless communication circuit to transmit a second transmission signal among the transmission signals using a second communication scheme, and
wherein the wireless communication circuit further includes a power switch configured to be included in or connected to a power amplification circuit configured to support a frequency band of a low output frequency among the plurality of amplification circuits.

7. A method for operation in an electronic device, the method comprising:
identifying power amplification circuits for amplifying, respectively, transmission signals input through a wireless communication circuit (210) of the electronic device;
based on the identified power amplification circuits being connected to a first power modulator (331) included in the wireless communication circuit, controlling a power switch (401, 501, or 503) included in the wireless communication circuit to connect a first power amplification circuit (321, 324, or 325) among the identified power amplification circuits to a second power modulator (332) included in the wireless communication circuit to simultaneously transmit the transmission signals using the identified power amplification circuits; and
based on the identified power amplification circuits being connected to the different first power modulator and second modulator, respectively, controlling the power switch to connect a first power amplification circuit among the identified power amplification circuits to the first power modulator to simultaneously transmit the transmission signals using the identified power amplification circuits.

8. The method of claim 7, wherein the power switch is connected to the first power amplification circuit,
wherein the first power modulator is connected to the power switch and a third power amplification circuit (323) among the plurality of amplification circuits, and
wherein the second power modulator is connected to the power switch and at least one power amplification circuit including a second power amplification circuit (322) among the plurality of amplification circuits.

9. The method of claim 7 or 8, further comprising:
controlling the first power amplification circuit connected to the second power modulator to amplify a first transmission signal among the transmission signals;
controlling the third power amplification circuit connected to the first power modulator to amplify a second transmission signal among the transmission signals; and
controlling the wireless communication circuit to simultaneously transmit the first transmission signal amplified by the first power amplification circuit and the second transmission signal amplified by the third power amplification circuit.

10. The method of any one of claims 7 to 9, further comprising:
controlling the first power amplification circuit connected to the first power modulator to amplify a first transmission signal among the transmission signals;
controlling the second power amplification circuit connected to the second power modulator to amplify a second transmission signal among the transmission signals; and
controlling the wireless communication circuit to simultaneously transmit the first transmission signal amplified by the first power amplification circuit and the second transmission signal amplified by the second power amplification circuit.

11. The method of any one of claims 7 to 10, wherein controlling the wireless communication circuit to simultaneously transmit the first transmission signal amplified by the first power amplification circuit and the second transmission signal amplified by the third power amplification circuit includes:
controlling the wireless communication circuit to transmit the first transmission signal among the transmission signals using a first communication scheme; and
controlling the wireless communication circuit to transmit the second transmission signal among the transmission signals using a second communication scheme.

12. The method of any one of claims 7 to 11, wherein controlling the wireless communication circuit to simultaneously transmit the first transmission signal amplified by the first power amplification circuit and the second transmission signal amplified by the second power amplification circuit includes:
controlling the wireless communication circuit to transmit the first transmission signal among the transmission signals using a first communication scheme; and
controlling the wireless communication circuit to transmit the second transmission signal among the transmission signals using a second communication scheme.

13. The method of any one of claims 7 to 12, wherein the first power amplification circuit is configured to support any one of a first frequency band, a second frequency band, or a third frequency band, and is connected to the first power modulator or the second power modulator by the power switch based on a combination of frequency bands related to input transmission signals,
wherein the second power amplification circuit is configured to support a different frequency band from the first power amplification circuit and is connected to the first power modulator, and
wherein the third power amplification circuit is configured to support a different frequency band from the first power amplification circuit and is connected to the second power modulator.

14. A non-transitory storage medium storing a program including instructions that, when executed by a processor of an electronic device, enable the electronic device to:
identify power amplification circuits configured to support different frequency bands for amplifying, respectively, transmission signals input through a wireless communication circuit of the electronic device;
based on the identified power amplification circuits being connected to a first power modulator (331) included in the wireless communication circuit, control a power switch (401, 501, or 503) included in the wireless communication circuit to connect a first power amplification circuit (321, 324, or 325) among the identified power amplification circuits to a second power modulator (332) included in the wireless communication circuit to simultaneously transmit the transmission signals using the identified power amplification circuits; and
based on the identified power amplification circuits being connected to the different first power modulator and second modulator, respectively, control the power switch to connect a first power amplification circuit among the identified power amplification circuits to the first power modulator to simultaneously transmit the transmission signals using the identified power amplification circuits.

15. The non-transitory storage medium of claim 14, further comprising:
controlling the first power amplification circuit connected to the second power modulator to amplify a first transmission signal among the transmission signals;
controlling a third power amplification circuit (323) connected to the first power modulator to amplify a second transmission signal among the transmission signals; and
controlling the wireless communication circuit to simultaneously transmit the first transmission signal amplified by the first power amplification circuit and the second transmission signal amplified by the third power amplification circuit.
